**Europäisches Patentamt**

**European Patent Office**

**Office européen des brevets**

(11) Veröffentlichungsnummer: **0 195 940**
**A1**

# (12) EUROPÄISCHE PATENTANMELDUNG

(21) Anmeldenummer: 86102389.3

(22) Anmeldetag: 24.02.86

(51) Int. Cl.⁴: **G11C 8/00**

(30) Priorität: 25.02.85 DE 3506574

(43) Veröffentlichungstag der Anmeldung:
01.10.86 Patentblatt 86/40

(84) Benannte Vertragsstaaten:
AT BE DE FR GB IT NL SE

(71) Anmelder: **Siemens Aktiengesellschaft Berlin und München**
**Wittelsbacherplatz 2**
**D-8000 München 2(DE)**

(72) Erfinder: **Tielert, Reinhard, Dr.**
**Lehrer-Götz-Weg 24**
**D-8000 München 82(DE)**

(54) **Schaltungsanordnung mit einer matrixförmigen Speicheranordnung zur variabel einstellbaren Verzögerung digitaler Signale.**

(57) Eine Schaltungsanordnung mit einer matrixförmigen Speicheranordnung zur variabel einstellbaren Verzögerung digitaler Signale mit speichernden Elementen, mit überlappenden Schreib-/Lesezyklen und einem taktgesteuerten, kontinuierlich fortschaltbaren, jederzeit rücksetzbaren, ansonsten zyklisch umlaufenden Zeilenwähler (P1-Pn), der je zwei in der Phase gegeneinander versetzte Signalausgänge je Wählschritt aufweist, die jeweils eine Schreibwortleitung - (ws) bzw. eine Lesewortleitung (wl) einer Zeile der Matrix ansteuern. Je Spalte sind zwei getrennte Bitleitungen -eine Schreibbitleitung (be) und eine Lesebitleitung-(bl) vorgesehen, die jeweils mit allen Speicherzellen einer Spalte zusammengeschaltet sind. Der Dateneingang (Di) für die zu verzögernden Datensignale ist mit allen Schreibbitleitungen über den Spalten individuell zugeordnete Torschaltungen (T1-Tm) verbindbar, wobei jeweils nur eine von m Torschaltungen mittels eines Spaltenwählers (R1-Rm) aktiviert ist.

FIG 1

Schaltungsanordnung mit einer matrixförmigen Speicheranordnung zur variabel einstellbaren Verzögerung digitaler Signale.

Die vorliegende Erfindung betrifft eine Schaltungsanordnung zur variabel einstellbaren Verzögerung digitaler Signale mit einer matrixförmigen Speicheranordnung.

Auf dem Gebiet der digitalen Signalverarbeitung sowie auf dem Gebiet der Nachrichtentechnik werden vielfach Einrichtungen benötigt, mit deren Hilfe definierte Verzögerungen von digitalen Datenströmen bewirkt werden können. Definierte Verzögerungen werden beispielsweise zum Ausgleich von Laufzeiten verwendet. Bei einer konstanten Anzahl von gewünschten Verzögerungstakten bietet sich im allgemeinen als Verzögerungseinrichtung eine Anordnung mit einem Schieberegister an. Soll jedoch die Verzögerung variabel einstellbar sein, so ergeben sich bei Verwendung von Schieberegistern bestimmte Probleme.

Es ist auch bekannt, Datenströme definiert mittels einer Anordnung aus Standardschaltungen und Speicherbausteinen zu verzögern. In einer derartigen Anordnung werden die Bestandteile des Datenstromes in einem frei adressierbaren Speicher abgelegt. Dieser Speicher wird durch einen Decoder angesteuert, der seinerseits durch einen (oder mehrere) Zähler angesteuert wird. Dabei wird die Dauer der Verzögerung durch den Abstand der Zähler-Rücksetzimpulse gegeben. Da die Speicherzellen derartiger frei adressierbarer Speicher je Takt nur jeweils lesen oder - schreiben können, ergibt sich dabei die Notwendigkeit, entweder die Speicher mit der doppelten Taktrate zu betreiben oder zwischen zwei Speichereinheiten in einem Multiplex-Betrieb hin-und herzuschalten. Die erste Lösung dieses Problems hat den Nachteil, daß die maximale Datentaktfrequenz nur halb so groß wie die maximale Speicherzyklusfrequenz sein darf. Die Lösung des letzteren Problems erfordert aufwendige Logikschaltungen zur Adreßsteuerung und einer erforderlichen Umordnung der Daten. Für eine integrierbare Realisierung einer derartigen Schaltungsanordnung entstehen außerdem Nachteile wegen des hohen Platzbedarfs der notwendigen Multiplexer und wegen der erforderlichen umfangreichen Verdrahtung.

Der vorliegenden Erfindung liegt die Aufgabe zugrunde, eine Schaltungsanordnung der eingangs genannten Art zu - schaffen, mittels derer definierte, variabel einstellbare Verzögerungen in feinen Abstufungen erzielt werden können, die durch eine integrierte Schaltungsanordnung realisierbar ist, die einen geringen Flächenbedarf benötigt und gegenüber dem Stand der Technik höhere Datenraten zuläßt. Insbesondere besteht die Aufgabe darin, eine Schaltungsanordnung zu schaffen, die für die Integration in MOS-Technik besonders geeignet ist.

Die Aufgabe, die der vorliegenden Erfindung zugrundeliegt, wird durch eine Schaltungsanordnung zur variabel einstellbaren Verzögerung digitaler Signale mit einer matrixförmigen Speicheranordnung gelöst, die durch die in dem kennzeichnenden Teil des Patentanspruchs 1 angegebenen Merkmale charakterisiert ist.

Vorteilhafte Weiterbildungen der vorliegenden Erfindung sind durch die in den Unteransprüchen angegebenen Merkmale gekennzeichnet.

Im folgenden wird die Erfindung anhand mehrerer, Ausführungsbeispiele für die vorliegende Erfindung betreffender Figuren im einzelnen erläutert.

Fig.1 zeigt ein Blockschaltbild der Schaltungsanordnung gemäß einem bevorzugten Ausführungsbeispiel, bei der ein Zeilenwähler, eine matrixförmige Speicheranordnung, Regeneratorschaltungen, eine Taktsteuerung, Torschaltungen, ein Spaltenwähler, eine Verzögerungszeit-Einstellanordnung sowie eine Rücksetzanordnung vorgesehen sind.

Fig.2 zeigt ein Impuls/Zeit-Diagramm zur Erläuterung der Arbeitsweise der Schaltungsanordnung gemäß Fig.1.

Fig.3 zeigt die in Fig.1 enthaltene symbolische Darstellung und ein Prinzipschaltbild einer 3-Transistorspeicherzelle, wie sie n x m-fach in der Speicheranordnung gemäß Fig.1 verwendet wird.

Fig.4 zeigt die in Fig.1 enthaltene symbolische Darstellung sowie ein Prinzipschaltbild eines Regenerators (Verstärkerschaltung), wie er m-fach in der Schaltungsanordnung gemäß Fig.1 verwendet wird.

Fig.5 zeigt die in Fig.1 enthaltene symbolische Darstellung einer Zeilenwählerstufe sowie deren Prinzipschaltbild, welche Stufen in der Schaltungsanordnung gemäß Fig.1 n-fach verwendet werden.

Fig.6 zeigt die in Fig.1 enthaltene symbolische Darstellung sowie ein Prinzipschaltbild einer der m Torschaltungen.

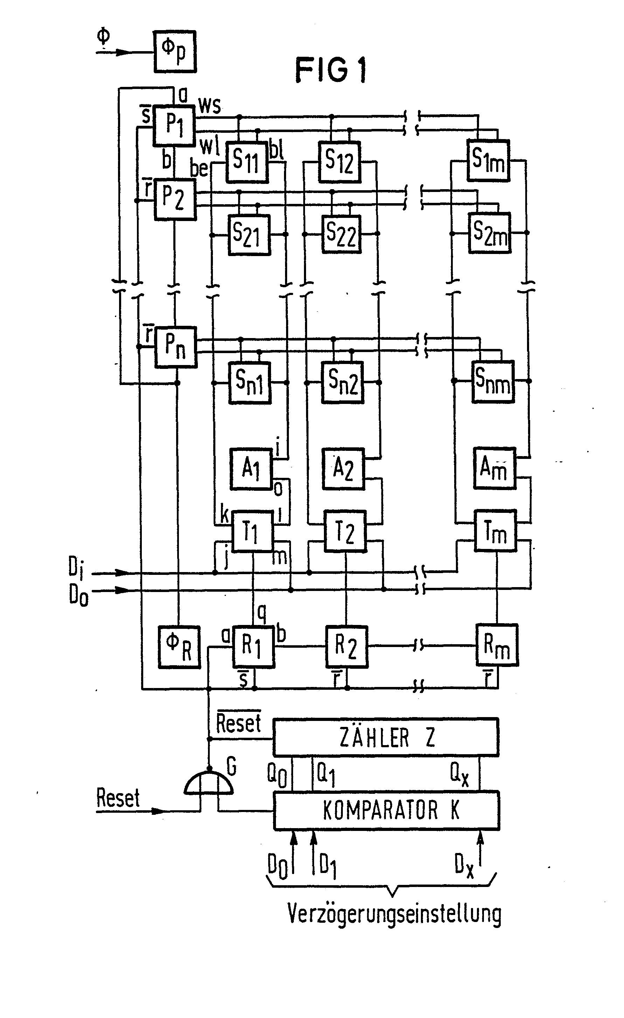

Wie bereits erläutert, zeigt Fig.1 ein bevorzugtes Ausführungsbeispiel für eine Schaltungsanordnung zur variabel einstellbaren Verzögerung digitaler Signale mit einer matrixförmigen Speicheranordnung gemäß der vorliegenden Erfindung.

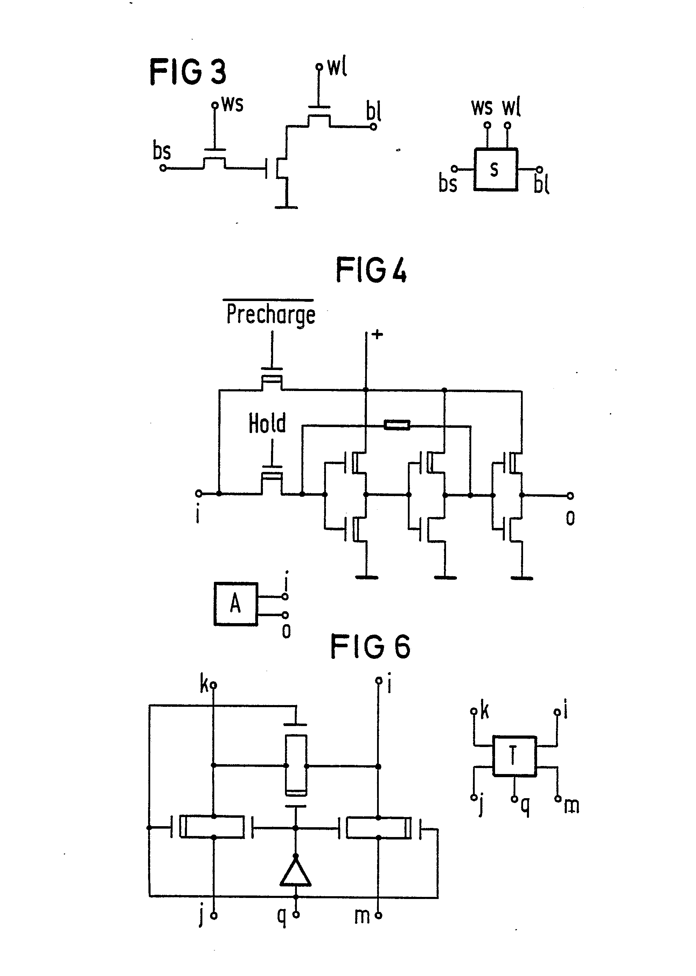

Die gezeigte Schaltungsanordnung enthält einen Dateneingang D, einen Rücksetzeingang $\overline{Reset}$, einen Takteingang $\emptyset$, der eine Taktsteuerung $\emptyset_P$ synchronisiert, sowie einen Datenausgang $D_o$. Außerdem ist ein zyklisch umlaufender Zeilenwähler mit Stufen $P_1...P_n$ vorgesehen, bei dem die Stufen in einer Reihe zusammengeschaltet sind, bei dem die erste Stufe $P_1$ mit einem Setzeingang $\overline{s}$ und die restlichen Stufen $P_2...P_n$ mit ihren jeweiligen Rücksetzeingängen $\overline{r}$ an eine Rücksetzleitung $\overline{Reset}$ angeschlossen sind, bei dem jeweils ein Signalausgang b mit einem Signaleingang a der jeweils folgenden Stufe verbunden ist und bei dem jeweils je Stufe eine Schreibwortleitung ws und eine Lesewortleitung wl vorgesehen sind. Als speichernde Elemente sind in der matrixförmigen Speicheranordnung an sich bekannte 3-Transistorspeicherzellen mit überlappenden Schreib-/Lesezyklen vorgesehen - (vergl. Fig.3). Der kontinuierlich fortschaltbare, jederzeit rücksetzbare Zeilenwähler $P_1...P_n$ wird von einem Eingangsdatentakt taktgesteuert. Er weist je Wählschritt, nämlich je Stufe, zwei in der Phase gegeneinander versetzte Signalausgänge -nämlich die Schreibwortleitung ws bzw. die Lesewortleitung wl - auf, die je Zeile der Matrix vorgesehen sind. In der Speicheranordnung sind je Spalte zwei getrennte Bitleitungen -nämlich eine Schreibbitleitung bs und eine Lesebitleitung bl -vorgesehen, die jeweils mit allen Speicherzellen einer Spalte zusammengeschaltet sind. Außerdem ist je Spalte ein abtrennbarer, speichernder, invertierender Verstärker $A_1...A_m$ vorgesehen, dessen Eingang i mit der Lesebitleitung bl der ihm zugeordneten Spalte und dessen Ausgang o über eine Torschaltung $T_1...T_m$ je nach deren Schaltzustand entweder mit der Schreibbitleitung bs derselben Spalte oder einem Datenausgang verbunden ist, in welchem letzteren Schaltzustand ein Dateneingang mit der Schreibbitleitung derselben Spalte verbunden ist. Der Dateneingang für die zu verzögernden Datensignale ist mit allen Schreibbitleitungen bs über die den Spalten individuell zugeordneten Torschaltungen

T₁...Tₘ verbindbar, wobei jeweils nur eine der m Torschaltungen mittels eines Spaltenwählers R₁...Rₘ aktiviert ist. Der Spaltenwähler R₁...Rₘ wird von einem Takt $\emptyset_R$ gesteuert, der aus dem Übertrag der letzten Stufe Pₙ des Zeilenwählers P₁...Pₙ gebildet wird. Eine Rücksetzleitung $\overline{Reset}$ ist mit Setzeingängen a, $\overline{s}$ eines ersten Gliedes P₁ des Zeilenwählers und eines ersten Gliedes R₁ des Spaltenwählers, mit den Rücksetzeingängen $\overline{r}$ der restlichen Glieder P₁...Pₙ des Zeilenwählers und den Rücksetzeingängen $\overline{r}$ der restlichen Glieder R₂...R ₘ des Spaltenwählers sowie dem Rücksetzeingang $\overline{r}$ eines die Impulse des Eingangsdatentaktes abzählenden Zählers Z verbunden. Ein Rücksetzsignal für die Rücksetzleitung $\overline{Reset}$ wird aus einem Verknüpfungsglied G gewonnen, dem über einen ersten Eingang ein externes Rücksetzsignal Reset und über einen zweiten Eingang ein internes Rücksetzsignal aus einem Komparator K zugeführt wird, welchem Komparator K über Wähleingänge D₁...D_X Signale zugeführt werden, die die Anzahl der Schritte des Zählers Z bestimmen, nach deren Ausführung das $\overline{Reset}$-Signal erzeugt wird. Das Intervall zwischen den Rücksetzimpulsen entspricht der geforderten Verzögerungszeit.

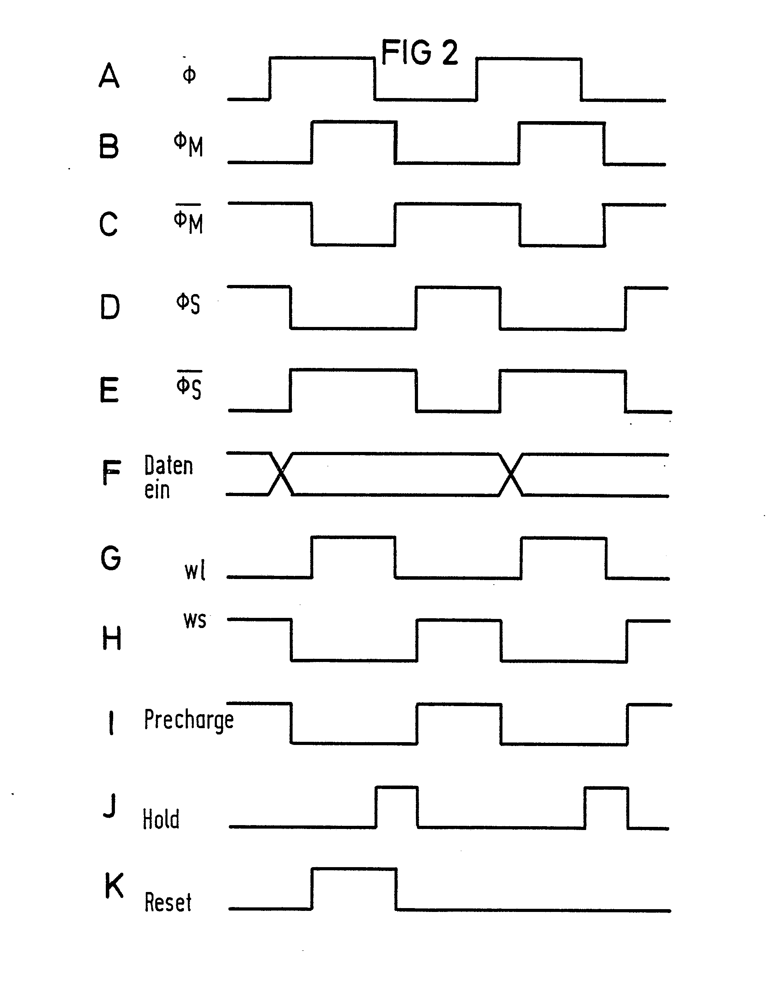

Wie bereits erläutert, zeigt Fig.2 ein Impuls/Zeit-Diagramm zur Erläuterung der Arbeitsweise der erfindungsgemäßen Schaltungsanordnung.

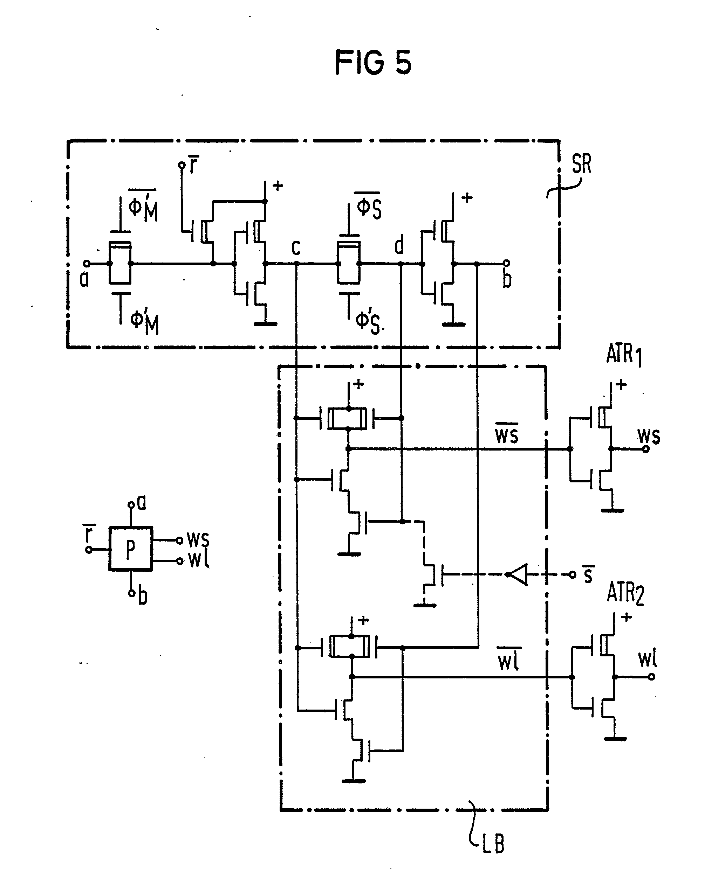

In Fig.2A ist der an die Taktsteuerung gelegte Grundtakt $\emptyset$ dargestellt. Daraus abgeleitete Hilfstakte zur Steuerung des Zeilenwählers (vergl. auch Fig.5), nämlich $\emptyset_M$, $\overline{\emptyset}_M$, $\emptyset_S$ und $\overline{\emptyset}_S$ sind in Fig.2B, 2C, 2D bzw. 2E gezeigt. Fig.2F zeigt die Phasenlage des Eingangsdatenstroms in bezug auf den Grundtakt $\emptyset$. In Fig.2G und 2H sind die Ausgangssignale des Zeilenwählers, nämlich das Lesewort-bzw. das Schreibwortleitungssignal wl bzw. ws, dargestellt. In Fig.2I und 2J sind ein Precharge-Signal bzw. ein Hold-Signal gezeigt, die zur Steuerung der Regeneratorschaltungen (vergl. auch Fig.4) verwendet werden. Fig.2K zeigt schließlich die Phasenlage des erforderlichen Reset-Signals in bezug auf den Grundtakt $\emptyset$.

Fig.3 zeigt, wie bereits erläutert, eine Darstellung der verwendeten 3-Transistorzelle, deren Prinzip darauf beruht, daß die zu speichernde Information dynamisch auf dem Gate eines MOS-Transistors (der mittleren der drei Transistoren) gespeichert wird. Diese an sich bekannte 3-Transistorspeicherzelle wird -wie durch Klemmenbezeichnung angegeben -in einer speziellen Betriebsart verwendet, bei der zum Lesen und Schreiben getrennte Bitleitungen benutzt werden (vergl. Fig.1), wodurch sich die Möglichkeit des Lesens und Schreibens in einem einzigen Taktzyklus ergibt, was vorteilhafterweise zu der angestrebten Zeitersparnis führt.

Fig.4 zeigt, wie bereits erläutert, eine Darstellung eines Verstärkers oder Regenerators. Die Aufgabe dieses Regenerators besteht darin, das auf der seinem Eingang i zugeordneten Lesebitleitung bl auftretende geschwächte Lesesignal auf den Normalpegel zu verstärken und dieses an den seinem Ausgang o zugeordneten Eingang l der zugeordneten Torschaltung T abzugeben. Die Schaltung dieses Regenerators enthält eine dreistufige Inverteranordnung mit einem darin enthaltenen Mitkopplungspfad. Der Inverteranordnung ist ein Schalter vorgeordnet, der jedesmal dann, wenn die Lesebitleitung für den nächsten Taktzyklus vorgeladen wird -gesteuert von dem Hold-Signal -die Inverteranordnung von dem Eingang i abtrennt und dadurch die eingespeicherte Information festhält. Dabei wird das Vorladen von einem durch das $\overline{Precharge}$-Signal gesteuerten weiteren Schalter bewirkt.

Die in Fig.1 gezeigte Schaltungsanordnung kann gemäß einer vorteilhaften Weiterbildung der Erfindung entsprechend der Wortbreite der Eingangsdaten mehrfach vorgesehen sein, wobei die Wortschreib-bzw. Wortleseleitungen ws bzw. wl dieser Speichermatrizen parallelgeschaltet und mit einem gemeinsamen für diese Speichermatrizen vorgesehenen Zeilenwähler P₀...Pₙ verbunden sind. Außerdem kann der Spaltenwähler, der die Torschaltungen steuert, gemeinsam für diese Speichermatrizen angeordnet sein.

Eine andere Weiterbildung der Erfindung sieht vor, daß der Zeilenwähler P₁...Pₙ jeweils aus einem Schieberegister SR, einem Verknüpfungsblock LB und zwei Ausgangstreibern ATR₁, ATR₂ mit Ausgängen ws bzw. wl je Glied des Zeilenwählers besteht und daß die Phasenlagen und Impulsbreiten der Ausgangssignale in den Ausgängen ws und wl durch entsprechende Verknüpfungen dreier in dem Schieberegister SR vorhandener Abgriffe bewirkt werden.

Fig.5 zeigt, wie bereits erläutert, die Darstellung einer Zeilenwählerstufe P. In einem Schieberegisterblock SR sind zwei dynamische Registerstufen, die durch mittels Hilfstakten $\overline{\emptyset}'_M$, $\emptyset'_M$; $\overline{\emptyset}_S$, $\emptyset_S$ gesteuerte Schalter voneinander bzw. von dem Signaleingang a trennbar sind, vorgesehen. Die Hilfstakte $\overline{\emptyset}'_M$ und $\emptyset'_M$ entsprechen den Hilfstakten $\overline{\emptyset}_M$ und $\emptyset_M$ gemäß Fig.2. Sie stellen allerdings Ergebnissignale einer Verknüpfung der betreffenden in Fig.2 gezeigten Signale mit dem Reset-Signal dar. Diese Verknüpfung bewirkt ein Schließen des Schalters am Eingang des Schieberegisterblocks SR für die Dauer des Reset-Signals. In einem Logikblock LB sind zwei Verknüpfungsglieder vorgesehen, die die an den Punkten c, d, b, auftretenden Signale nach folgenden Funktionen miteinander verknüpfen:

$$\overline{ws} = \overline{c \wedge d}$$

$$\overline{wl} = \overline{c \wedge b}$$

Die Ausgangssignale $\overline{ws}$ und $\overline{wl}$ des Logikblocks LB werden mittels invertierender Treiber auf die Schreibwortleitung ws bzw. die Lesewortleitung der zugehörigen Zeile der matrixförmigen Speicheranordnung geschaltet. Es ist für die Stufen P₂...Pₙ des Zeilenwählers gemäß Fig.1 jeweils ein Reset-Eingang $\overline{r}$ vorgesehen. An dessen Stelle tritt bei der Stufe P₁ ein Setzeingang $\overline{s}$, wie dies in Fig.5 gestrichelt angedeutet ist.

Fig.6 zeigt, wie bereits erläutert, den Aufbau einer der m Torschaltungen T, die die folgenden Funktionen aufweisen:

$q = O : m = l, k = j$

$q = l : m = z, k = l,$

wobei "z" indifferent ist.

Der Spaltenwähler $R_1...R_2$ ist vorzugsweise als eine Reihenanordnung mit statischen Schieberegistern realisiert, wobei diese Schieberegister durch einen von dem Taktsignal $\emptyset_R$ abgeleiteten Phasentakt geschaltet werden.

Die erfindungsgemäße Schaltungsanordnung ist von ihrem Aufbau her insbesondere dazu geeignet, als monolithisch integrierte MOS-Schaltung realisiert zu werden.

## Ansprüche

1. Schaltungsanordnung mit einer matrixförmigen Speicheranordnung zur variabel einstellbaren Verzögerung digitaler Signale,

dadurch **gekennzeichnet,**

-daß als speichernde Elemente an sich bekannte 3-Transistorzellen mit überlappenden Schreib-/Lesezyklen vorgesehen sind,

-daß ein taktgesteuerter, kontinuierlich fortschaltbarer, jederzeit rücksetzbarer, ansonsten zyklisch umlaufender Zeilenwähler $(P_1...P_n)$ vorgesehen ist, der je zwei in der Phase gegeneinander versetzte Signalausgänge je Wählschritt aufweist, die jeweils eine Schreibwortleitung (ws) bzw. eine Lesewortleitung (wl) ansteuern, welche je Zeile der Matrix vorgesehen sind,

-daß je Spalte zwei getrennte Bitleitungen, nämlich eine Schreibbitleitung (bs) und eine Lesebitleitung (bl) vorgesehen sind, die jeweils mit allen Speicherzellen einer Spalte zusammengeschaltet sind,

-daß je Spalte ein abtrennbarer, speichernder, invertierender Verstärker $(A_1...A_m)$ vorgesehen ist, dessen Eingang (i) mit der Lesebitleitung (bl) der ihm zugeordneten Spalte und dessen Ausgang (o) über eine Torschaltung $(T_1...T_m)$ je nach deren Schaltzustand entweder mit der Schreibbitleitung (bs) derselben Spalte oder einem Datenausgang verbunden ist, in welchem letzteren Schaltzustand ein Dateneingang mit der Schreibbitleitung derselben Spalte verbunden ist,

-daß der Dateneingang für die zu verzögernden Datensignale mit allen Schreibbitleitungen (bs) über die den Spalten individuell zugeordneten Torschaltungen $(T_1...T_m)$ verbindbar ist, wobei jeweils nur eine der m Torschaltungen mittels eines Spaltenwählers $(R_1...R_m)$ aktiviert ist,

-daß der Spaltenwähler $(R_1...R_m)$ von einem Takt $(\emptyset_R)$ gesteuert wird, der aus dem Übertrag der letzten Stufe $(P_n)$ des Zeilenwählers $(P_1...P_n)$ gebildet wird,

-daß eine Rücksetzleitung ($\overline{Reset}$) mit Setzeingängen (a, $\overline{s}$ ) eines ersten Gliedes $(P_1)$ des Zeilenwählers und eines ersten Gliedes $(R_1)$ des Spaltenwählers, mit den Rücksetzeingängen ( $\overline{r}$ ) der restlichen Glieder $(P_2...P_n)$ des Zeilenwählers und den Rücksetzeingängen ( $\overline{r}$ ) der restlichen Glieder $(R_2...R_m)$ des Spaltenwählers sowie dem Rücksetzeingang ( $\overline{r}$ ) eines die Impulse des Eingangsdatentaktes abzählenden Zählers (Z) verbunden ist und

-daß ein Rücksetzsignal für die Rücksetzleitung ($\overline{Reset}$) aus einem Verknüpfungsglied (G) gewonnen wird, dem über einen ersten Eingang ein externes Rücksetzsignal (Reset) und über einen zweiten Eingang ein internes Rücksetzsignal aus einem Komparator (K) zugeführt wird, welchem Komparator (K) über Wähleingänge $(D_1...D_x)$ Signale zugeführt werden, die die Anzahl der Schritte des Zählers (Z) bestimmen, nach deren Ausführung das $\overline{Reset}$-Signal erzeugt wird.

2. Schaltungsanordnung nach Anspruch 1, dadurch **gekennzeichnet,** daß entsprechend der Wortbreite der Eingangsdaten eine Vielzahl von Speichermatrizen vorgesehen sind, deren Wortschreib-bzw. Wortleseleitungen (ws bzw. wl) parallelgeschaltet und mit dem gemeinsamen für diese Speichermatrizen vorgesehenen Zeilenwähler $(P_0...P_n)$ verbunden sind, und daß der Spaltenwähler $(R_1...R_m)$ gemeinsam für diese Vielzahl von Speichermatrizen vorgesehen ist.

3. Schaltungsanordnung nach Anspruch 1, dadurch **gekennzeichnet,** daß der Zeilenwähler $(P_1...P_n)$ jeweils aus einem Schieberegister (SR), einem Verknüpfungsblock - (LB) und zwei Ausgangstreibern $(ATR_1, ATR_2)$ mit Ausgängen (ws bzw. wl) je Glied des Zeilenwählers besteht und daß die Phasenlagen und Impulsbreiten der Ausgangssignale an den Ausgängen (ws u. wl) durch entsprechende Verknüpfungen dreier in dem Schieberegister (SR) vorhandener Abgriffe bewirkt werden.

4. Schaltungsanordnung nach einem der vorhergehenden Ansprüche, dadurch **gekennzeichnet,** daß sie als monolithisch integrierte MOS-Schaltung realisiert ist.

# FIG 1

Verzögerungseinstellung

FIG 2

| | | |
|---|---|---|
| A | $\phi$ | |
| B | $\phi_M$ | |
| C | $\overline{\phi_M}$ | |
| D | $\phi_S$ | |
| E | $\overline{\phi_S}$ | |
| F | Daten ein | |
| G | wl | |
| H | ws | |
| I | Precharge | |
| J | Hold | |
| K | Reset | |

**FIG 3**

**FIG 4**

**FIG 6**

# FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 731 287 (SEELY et al.) <br> * Figuren 2,4A,4B; Spalte 17, Zeile 59 - Spalte 18, Zeile 44 * <br><br> --- | 1,2,4 | G 11 C 8/00 |
| Y | EP-A-0 031 950 (NEC CORP.) <br> * Figuren 9,13,16; Seite 21, Zeilen 17-33; Seite 22, Zeile 20 - Seite 23, Zeile 1 * <br><br> --- | 1,2,4 | |
| Y | US-A-3 893 088 (BELL) <br> * Figuren 1,10A; Spalte 2, Zeilen 42-66 * <br><br> ----- | 1,2,4 | |

| RECHERCHIERTE SACHGEBIETE (Int. Cl.4) |
|---|
| G 11 C 8/00 |

Der vorliegende Recherchenbericht wurde für alle Patentansprüche erstellt.

| Recherchenort <br> DEN HAAG | Abschlußdatum der Recherche <br> 09-06-1986 | Prüfer <br> SONIUS M.E. |
|---|---|---|